# EUROPEAN PATENT APPLICATION

(11) **EP 4 472 180 A1**
(43) Date of publication of application: **04.12.2024**
(21) Application number: 23792057.4
(22) Date of filing: 31.03.2023
(51) Int. Cl.: H04M 1/02, H02J 7/00, H01M 50/284

(54) **ELECTRONIC DEVICE CAPABLE OF FAST CHARGING**

(30) Priority: 22.04.2022 KR 20220049979; 26.05.2022 KR 20220064695
(71) Applicant: Samsung Electronics Co., Ltd, Suwon-si, Gyeonggi-do 16677 (KR)
(72) Inventor: JEONG, Kiyeong, Suwon-si Gyeonggi-do 16677 (KR); JU, Wanjae, Suwon-si Gyeonggi-do 16677 (KR)
(74) Representative: HGF
(86) International application number: PCT/KR2023/004369
(87) International publication number: WO 2023/204477

(57) **Abstract**

An electronic device capable of selectively performing normal charging and fast charging, according to an embodiment, may comprise: a battery which has a first surface and a second surface facing a different direction from that of the first surface, and includes a first connection member and a second connection member; a first PCB which is connected to the first connection member and disposed closer to the first surface than to the second surface of the battery; a second PCB which is connected to the second connection member and disposed closer to the second surface than to the first surface of the battery; a first charging IC and a second charging IC which supply power to the battery; a processor which is disposed at the first PCB and selects one of fast charging and normal charging of the battery on the basis of a charging algorithm; and a charging port which is connected to the second PCB, wherein the processor turns off the second charging IC in order to perform normal charging of the battery and turns on the second charging IC in order to perform fast charging of the battery, and the second charging IC is disposed at the second PCB and supplies power from the second PCB to the battery through the second connection member. Various other embodiments may also be possible.

## Description

### Technical FIELD

Various embodiments in the present disclosure relate to an electronic device capable of fast charging.

### Background ART

Technological advancements have enabled various types of electronic devices to include high-performance hardware, and accordingly, various studies have been conducted to improve the performance of batteries. For example, the demands for miniaturization put a limit on a battery capacity that may be secured by portable electronic devices. To overcome this, batteries had to be frequently charged or power banks had to be carried.

Against this backdrop, for relatively rapid charging of batteries of electronic devices, electronic devices having a high-speed charging function that applies high current to batteries have been developed. The electronic devices capable of fast charging may charge their batteries in at least one method of normal charging or fast charging given various conditions, such as the state or use environment of the electronic devices.

### DISCLOSURE OF THE INVENTION

### TECHNICAL GOALS

An electronic device capable of fast charging may go through a size increase in components through which high current passes, and accordingly, an area occupied by those components in the electronic device may also increase. Alternatively, when a route for charging gets longer, a DC resistance (DCR) may get higher, and as high current flows during fast charging, power loss may occur. In turn, heat may be generated in the electronic device, and charging efficiency may decline.

The electronic device capable of fast charging may need to include separate heat dissipation means to alleviate heat generation. The inclusion of the heat dissipation means may raise the manufacturing costs of the electronic device, may hinder the miniaturization of the electronic device, and may hinder improving charging speed.

An electronic device according to various embodiments in the present disclosure may include a fast-charging route having characteristics discrete from normal charging and/or discharging routes.

The technical goals to be achieved through embodiments of the present disclosure are not limited to those described above, and other technical goals not mentioned above are clearly understood by one of ordinary skill in the art from the following description.

### TECHNICAL SOLUTIONS

According to various example embodiments, an electronic device includes: a battery including a first surface and a second surface facing a different direction than the first surface and including a first connector and a second connector, a first printed circuit board (PCB) connected to the first connector and relatively closer to the first surface of the battery than the second surface of the battery, a second PCB connected to the second connector and relatively closer to the second surface of the battery than the first surface of the battery, a first charging integrated circuit (IC) and a second charging IC both configured to supply power to the battery, a processor disposed on the first PCB and configured to select between fast charging and normal charging of the battery based on a charging algorithm, and a charging port connected to the second PCB, in which the processor is configured to turn off the second charging IC for the normal charging of the battery and configured to turn on the second charging IC for the fast charging of the battery, and the second charging IC is disposed on the second PCB and configured to supply power from the second PCB to the battery through the second connector. In addition, there may be other embodiments.

In addition, an electronic device optionally capable of normal charging and fast charging includes: a battery including a first surface and a second surface facing a different direction from than the first surface and including a first connector and a second connector, a first printed circuit board (PCB) connected to the first connector and relatively closer to the first surface of the battery than the second surface of the battery, a second PCB connected to the second connector and relatively closer to the second surface than the first surface of the battery, a first charging integrated circuit (IC) and a second charging IC that are configured to supply power to the battery, a cable configured to supply power from the second PCB to the first PCB, a processor disposed on the first PCB and configured to select between fast charging and normal charging of the battery based on a charging algorithm, and a charging port connected to the second PCB, wherein the processor is configured to turn off the second charging IC for the normal charging of the battery and to turn on the second charging IC for the fast charging of the battery, the first charging IC is disposed on the first PCB and configured to supply power from the first PCB to the battery through the first connector, wherein the second charging IC is disposed on the second PCB and configured to supply power from the second PCB to the battery through the second connector.

### EFFECTS OF THE INVENTION

According to various example embodiments, an electronic device may individualize a fast-charging route from a normal charging and/or discharging route to improve the charging efficiency of a battery and shorten a charging time of the battery.

In addition, according to various example embodiments, the electronic device may have advantageous effects in heat dissipation design and the miniaturization and thinning of the electronic device by shortening the fast-charging route.

The effects of the electronic device according to various embodiments are not limited to the above-mentioned effects, and other unmentioned effects can be clearly understood from the following description by one of ordinary skill in the art.

### BRIEF DESCRIPTION OF DRAWINGS

FIG. 1 is a block diagram illustrating an electronic device in a network environment, according to various embodiments
FIG. 2A is a front perspective view of an electronic device according to an embodiment.
FIG. 2B is a rear perspective view of the electronic device according to an embodiment.
FIG. 3 is an exploded perspective view of the electronic device according to an embodiment.
FIG. 4A is a plan view of the electronic device according to an embodiment.
FIG. 4B is a diagram illustrating charging and discharging routes of the electronic device according to an embodiment.
FIG. 5A is a rear view of the electronic device according to an embodiment.
FIG. 5B is a diagram illustrating charging and discharging routes of the electronic device according to an embodiment.
FIG. 6 is a diagram illustrating a multi-layer structure of a battery cell according to an embodiment.
FIG. 7A is a diagram illustrating a connection structure of a battery according to an embodiment.
FIG. 7B is a diagram illustrating a connection structure of the battery according to an embodiment.
FIG. 7C is a diagram illustrating a connection structure of the battery according to an embodiment.
FIG. 7D is a diagram illustrating a connection structure of the battery according to an embodiment.
FIG. 8A is a rear view of the electronic device according to an embodiment.
FIG. 8B is a rear view of the electronic device according to an embodiment.
FIG. 9A is a rear view of the electronic device according to an embodiment.
FIG. 9B is a diagram illustrating charging and discharging routes of the electronic device according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

It should be appreciated that embodiments of the disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments of the present disclosure as set forth herein may be implemented as software (e.g., the program 120) including one or more instructions that are stored in a storage medium (e.g., an internal memory 136 or an external memory 138) that is readable by a machine (e.g., an electronic device). For example, a processor of the machine (e.g., an electronic device) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to an embodiment, the integrated component may still perform one or more functions of each of the components in the same or similar manner as they are performed by a corresponding one among the components before the integration. According to an embodiment, operations performed by the module, the program, or another component may be carried out sequentially, in parallel, repeatedly, or heuristically, or one or more of the operations may be executed in a different order or omitted, or one or more other operations may be added.

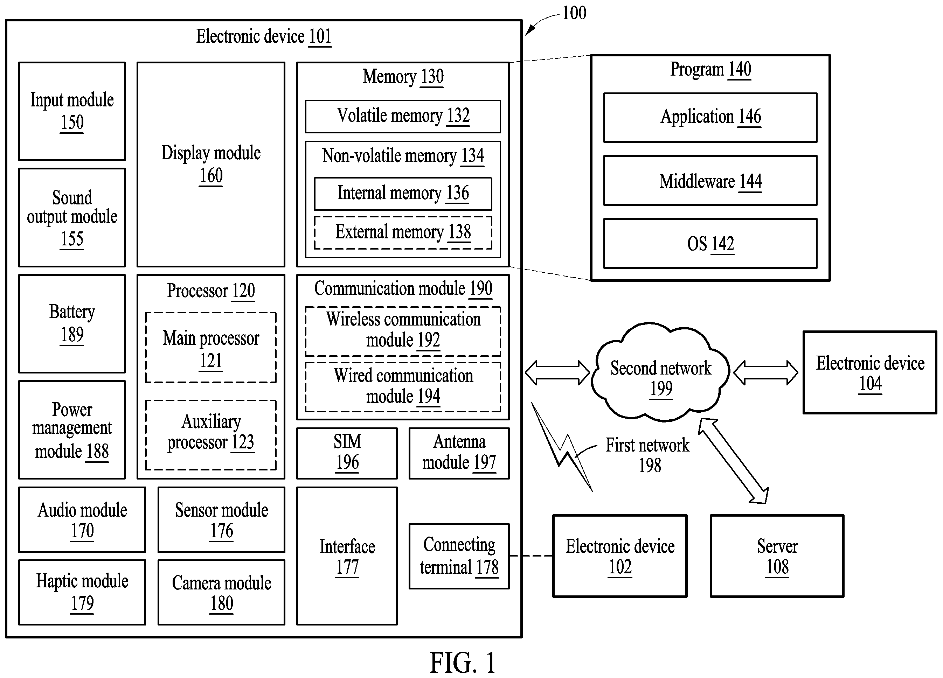

FIG. 1 is a block diagram illustrating an example electronic device 101 in a network environment 100, according to one embodiment. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some examples, at least one (e.g., the connecting terminal 178) of the above components may be omitted from the electronic device 101, or one or more other components may be added in the electronic device 101. In some examples, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101 instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated by machine learning. The machine learning may be performed by, for example, the electronic device 101, in which AI is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), and a deep Q-network or a combination of two or more thereof but is not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to an embodiment, the display device 160 may include a touch sensor adapted to sense a touch or a pressure sensor adapted to measure the intensity of a force incurred by the touch.

The audio module 170 may convert a sound into an electric signal or vice versa. According to an embodiment, the audio module 170 may obtain the sound via the input module 150 or may output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101 and may generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may physically connect to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell that is not rechargeable, a secondary cell that is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, Wi-Fi direct, or IR data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip) or may be implemented as multi-components (e.g., multi-chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra-low-latency services using, e.g., distributed computing or MEC. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic device may include, for example, a portable communication device (e.g., a smartphone), a computer device, a portable multimedia device, a portable medical device, a camera, a wearable device, a home appliance device, or the like. According to an embodiment of the disclosure, the electronic devices are not limited to those described above.

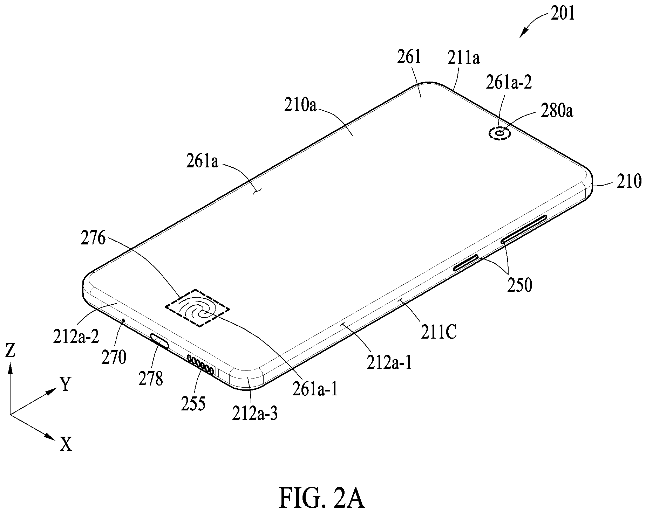

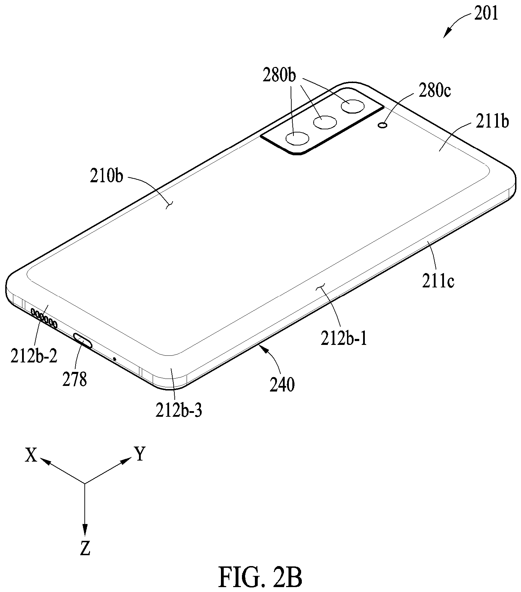

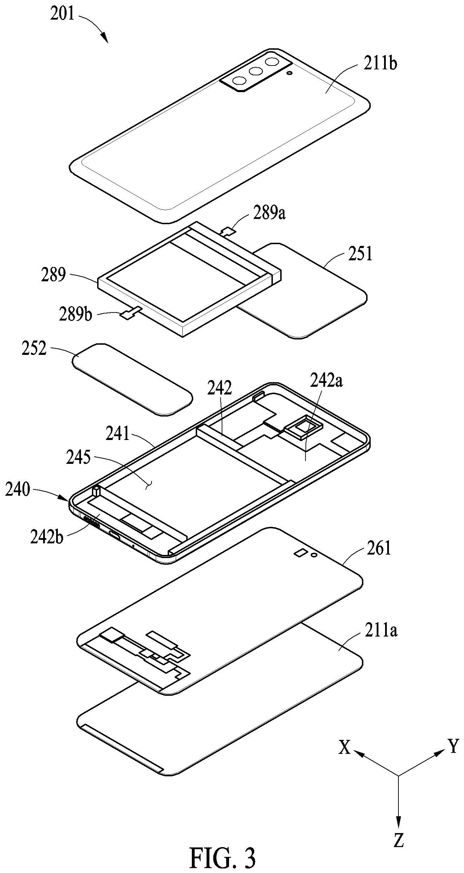

FIG. 2A is a front perspective view of an electronic device 201 according to an embodiment, FIG. 2B is a rear perspective view of the electronic device 201 according to an embodiment, and FIG. 3 is an exploded perspective view of the electronic device 201 according to an embodiment.

Referring to 2A, 2B, and 3, the electronic device 201 (e.g., the electronic device 101 of FIG. 1) according to an embodiment may include a housing 210 forming an exterior and accommodating a component, and the housing 210 may include a front surface 210a (e.g., a first surface), a rear surface 210b (e.g., a second surface), and a side surface 211c (e.g., a third surface) enclosing an inner space between the front surface 210a and the rear surface 210b.

The electronic device 201 according to an embodiment may include the housing 210 including the first surface (or the front surface) 210a, the second surface (or the rear surface) 210b, and the side surface 210c enclosing a space between the first surface 210 and the second surface 210b. In another embodiment (not shown), a housing may refer to a structure forming a portion of the first surface 210a, the second surface 210b, and the side surface 210c of FIGS. 2A and 2B. According to an embodiment, the first surface 210a may be formed by a front plate 211a (e.g., a glass plate or a polymer plate including various coating layers) of which at least a portion is substantially transparent. The second surface 210b may be formed by a rear plate 211b that is substantially opaque. For example, the rear plate 211b may be formed of coated or colored glass, ceramic, polymer, metal materials (e.g., aluminum, stainless steel (STS), or magnesium) or a combination of at least two of said materials. The side surface 210c may be coupled to the front plate 211a and the rear plate 211b and may be formed by a side structure (or a "side member") 240 including metal and/or polymer. In some embodiments, the rear plate 211b and the side structure 240 may be integrally formed and may include the same material (e.g., a metal material, like aluminum).

In an embodiment, the front plate 211a may include a plurality of first periphery areas 212a-1 that are rounded in a direction from at least one area of the front surface 210a toward the rear plate 211b and extend in one direction (e.g., a +/- X-axis direction), a plurality of second periphery areas 212a-2 that are rounded in the direction from at least one area of the front surface 210a toward the rear plate 211b and extend in the other direction (e.g., a +/- Y-axis direction), and a plurality of third periphery areas 212a-3 that are rounded in the direction from at least one area of the front surface 210a toward the rear plate 211b and disposed between the plurality of first periphery areas 212a-1 and the plurality of second periphery areas 212a-2.

In an embodiment, the rear plate 211b may include a plurality of fourth periphery areas 212b-1 that are rounded in a direction from at least one area of the rear surface 210b toward the front plate 211a and extend in one direction (e.g., the +/- X-axis direction), a plurality of fifth periphery areas 212b-2 that are rounded in the direction from at least one area of the rear surface 210b toward the front plate 211a and extend in the other direction (e.g., the +/- Y-axis direction), and a plurality of sixth periphery areas 212b-3 that are rounded in the direction from at least one area of the rear surface 210b toward the front plate 211a and disposed between the plurality of fourth periphery areas 212b-1 and the plurality of fifth periphery areas 212b-2.

In an embodiment, the front plate 211a may include two first areas 212a-1 that are curved and seamlessly extend from the first surface 210a toward the rear plate 211b at both ends of a long edge of the front plate 211a. In an embodiment, the rear plate 211b may include two second areas 212b-1 that are curved and extend seamlessly in a direction from the second surface 210b toward the front plate 211a at both ends of a long edge of the rear plate 211b. In an embodiment, the front plate 211a (or the rear plate 21 1b) may include only one of the first areas 212a-1 (or the second areas 212b-1). In an embodiment, some of the first areas 212a-1 or the second areas 212b-1 may not be included. In embodiments, in a side view of the electronic device 201, the side structure 240 may have a first thickness (or width) at a side surface not including the first areas 212a-1 or the second areas 212b-1 and may have a second thickness that is less than the first thickness at a side surface including the first areas 212a-1 or the second areas 212b-1.

In an embodiment, the side structure 240 may enclose at least a portion of the inner space between the front surface 210a and the rear surface 210b. The side structure 240 may include a first support structure 241 disposed on at least a portion of the side surface 211c and a second support structure 242 connected to the first support structure 241 to form a space for disposing the components of the electronic device 201. In various embodiments, the first support structure 241 and the second support structure 242 may be brackets and/or rear cases and may be formed of a metal material and/or non-metal material (e.g., polymer), for example.

In an embodiment, the side structure 240 may connect the periphery of the front plate 211a to the periphery of the rear plate 211b and may enclose the space between the front plate 211a and the rear plate 211b to form the side surface 211c of the housing 210. In an embodiment, the first support structure 241 or the second support structure 242 may be disposed inside (or in a body portion) of the electronic device 201. The second support structure 242 may be integrally formed with the first support structure 241 or may be formed separately from and connected to the first support structure 241. In an embodiment, the first support structure 241 and/or the second support structure 241 may be a component of the housing 210.

In an embodiment, PCB assemblies 251 and 252 may be disposed in the second support structure 242. For example, the second support structure 242 may be connected to the ground of PCB assemblies 251 and 252. In an embodiment, a display 261 may be disposed on a surface (e.g., a lower surface (a surface in a +Z-axis direction) of FIG. 3) of the second support structure 242, and the rear plate 211b may be disposed on the other surface (e.g., an upper surface (a surface in a -Z-axis direction) of FIG. 3) of the second support structure 242.

In an embodiment, at least a portion of the side structure 240 may be formed of a conductive material. For example, the first support structure 241 may be formed of a metal and/or conductive polymer material. In an embodiment, the second support structure 242 may be formed of a metal and/or conductive polymer material, like the first support structure 241.

In an embodiment, the electronic device 201 may include the display 261 (e.g., the display module 160 of FIG. 1). In an embodiment, the display 261 may be disposed on the front surface 210a. In an embodiment, the display 261 may be visible through at least a portion (e.g., a plurality of first periphery areas 212a-1, a plurality of second periphery areas 212a-2, and a plurality of third periphery areas 212a-3) of the front plate 211a. In an embodiment, the display 261 may have a shape that is substantially the same as the shape of an outer edge of the front plate 211a.

In an embodiment, the display 261 may be visible through a significant portion of the front plate 211a. In some embodiments, at least a portion of the display 301 may be visible through the first surface 210a and the front plate 211a forming the first areas 212a-1 of the side surface 210c. In some embodiments, an edge of the display 261 may be formed to be substantially the same as the shape of the periphery of the front plate 211a adjacent thereto. In another embodiment (not shown), a distance between the edge of the display 261 and the periphery of the front plate 211a may be substantially the same to expand a visible area of the display 261.

In an embodiment, the edge of the display 261 may substantially coincide with an outer edge of the front plate 211a. Although not illustrated in the drawings, the display 261, in various embodiments, may include a touch sensing circuit, a pressure sensor (not shown) for sensing the intensity (pressure) of a touch, and/or a digitizer (not shown) for detecting a magnetic-type stylus pen (not shown).

In an embodiment, the display 261 may include a screen display area 261a that is visible and displays content through a pixel or a plurality of cells. In an embodiment, the screen display area 261a may include a sensing area 261a-1 and a camera area 261a-2. In this case, the sensing area 261a-1 may overlap at least a portion of the screen display area 261a. The sensing area 261a-1 may allow the transmission of an input signal related to a sensor module 276 (e.g., the sensor module 176 of FIG. 1). The sensing area 261a-1 may display content, like the screen display area 261a that does not overlap the sensing area 261a-1.

For example, the sensing area 261a-1 may display the content while the sensor module 276 is not operating. The camera area 261a-2 may overlap at least a portion of the screen display area 261a. The camera area 261a-2 may allow the transmission of an optical signal related to camera modules 280a and 280b (e.g., the camera module 180 of FIG. 1). The camera area 261a-2 may display content, like the screen display area 261a that does not overlap the camera area 261a-2. For example, the camera area 261a-2 may display the content while the camera modules 280a and 280b are not operating.

In an embodiment, the electronic device 201 may include an audio module 270 (e.g., the audio module 170 of FIG. 1). The audio module 270 may obtain sound from the outside of the electronic device 201. For example, the audio module 270 may be disposed on one surface of the housing 210, for example, on the side surface 211c of the housing 210. In an embodiment, the audio module 270 may obtain sound through at least one hole.

In an embodiment, the audio module 270 may include a microphone hole and a speaker hole. The microphone hole may have a microphone inside to obtain external sound, and, in some embodiments, may have a plurality of microphones inside to detect a sound direction. The speaker hole may include an external speaker hole formed on the side surface 210a-1 of the electronic device 201. Although not illustrated in the drawings, the speaker hole may include a receiver hole (not shown) for a call formed on the first surface 210a of the electronic device 201 or the rear surface of the display 261. In some embodiments, the speaker hole and the microphone hole may be implemented as a single hole, or a speaker (e.g., a piezo speaker) may be included without the speaker hole.

In an embodiment, the electronic device 201 may include the sensor module 276. The sensor module 276 may sense a signal applied to the electronic device 201. The sensor module 276 may be positioned, for example, on the front surface 210a of the electronic device 201. The sensor module 276 may form the sensing area 261a-1 in at least a portion of the screen display area 261a.

In an embodiment, the sensor module 276 may receive an input signal transmitted through the sensing area 261a-1 and may generate an electrical signal based on the received input signal. For example, the input signal may have a designated physical quantity (e.g., heat, light, temperature, sound, pressure, or ultrasound). In another example, the input signal may include a signal related to the biometric information (e.g., a fingerprint, a voice, or the like) of a user.

In an embodiment, the sensor module 276 may generate an electrical signal or a data value corresponding to an internal operating state of the electronic device 201 or an external environmental state. Although not illustrated in the drawings, the sensor module 276 may include a proximity sensor disposed on the first surface 210a of the housing 210 and/or an HRM sensor disposed on the second surface 210b of the housing 210. The electronic device 201 may further include at least one of sensor modules (not shown), for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the electronic device 201 may include the camera modules 280a and 280b (e.g., the camera module 180 of FIG. 1). In an embodiment, the camera modules 280a and 280b may include the first camera module 280a and the second camera module 280b and may further include a flash 280c in various embodiments.

In an embodiment, the first camera module 280a may be disposed to be exposed through the front surface 210a of the housing 210, and the second camera module 280b and the flash 280c may be disposed to be exposed through the rear surface 210b of the housing 210. In an embodiment, at least a portion of the first camera module 280a may be disposed in the housing 210 to be covered through the display 261. In an embodiment, the first camera module 280a may receive an optical signal transmitted through the camera area 261a-2. In an embodiment, the second camera module 280b may include a plurality of cameras (e.g., dual cameras, triple cameras, or quad cameras). In an embodiment, the flash 280c may include a light-emitting diode or a xenon lamp.

In an embodiment, the electronic device 201 may include a sound output module 255 (e.g., the sound output module 155 of FIG. 1). The sound output module 255 may output sound to the outside of the electronic device 201. For example, the sound output module 255 may output sound to the outside of the electronic device 201 through one or more holes formed on the side surface 211c of the housing 210.

In an embodiment, the electronic device 201 may include a key input module 250 (e.g., the input module 150 of FIG. 1). The key input module 250 may receive a manipulation signal from the user. The key input module 250 may include, for example, at least one key input device disposed to be exposed on the side surface 211c of the housing 210.

In an embodiment, the electronic device 201 may include a connecting terminal 278 (e.g., the connecting terminal 178 of FIG. 1). In an embodiment, the connecting terminal 278 may be disposed on an outer circumferential surface of the housing 210 and, for example, may be disposed on a lower side surface 211c of the electronic device 201 as illustrated in FIG. 2A. Specifically, when the electronic device 201 is viewed in one direction (e.g., the +Y-axis direction of FIG. 2A), the connecting terminal 278 may be disposed on a central portion of the side surface 211c and the sound output module 255 may be disposed in a direction (e.g., a right direction) based on the connecting terminal 278.

As illustrated in FIGS. 2A and 2B, the audio module 270, the sound output module 255, and the connecting terminal 278 may be disposed on the side surface 211c of the housing 210 that forms the exterior of the electronic device 201. However, in actual implementation, examples are not limited thereto, and at least a portion of the connecting terminal 278 may be disposed on the front surface 210a or the rear surface 210b of the housing 210 or may be disposed inside the housing 210. For example, although not illustrated in the drawings, the housing 210 in an embodiment may include a cover (not shown) for replacing a battery 289.

In an embodiment, the electronic device 201 may include the battery 289 (e.g., the battery 189 of FIG. 1) and at least one PCB assembly 251 or 252 including one or more PCBs.

In an embodiment, the PCB assemblies 251 and 252 may include two PCBs that are spaced apart from each other. For example, the PCB assemblies 251 and 252 may include the first PCB 251 and the second PCB 252. In an embodiment, the first PCB 251 may be accommodated by a first substrate slot 242a of the second support structure 242, and the second PCB 252 may be accommodated by a second substrate slot 242b of the second support structure 242.

In an embodiment, the PCB assemblies 251 and 252 may be provided with a processor, a memory, and/or an interface. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high-definition multimedia interface (HDMI), a universal serial bus (USB) interface, an SD card interface, and/or an audio interface. For example, the interface may electrically or physically connect the electronic device 300 to an external electronic device and may include a USB connector, an SD card/multimedia card (MMC) connector, or an audio connector.

In an embodiment, the battery 289, which is a device for supplying power to at least one component of the electronic device 201, may include, for example, a primary cell that is not rechargeable, a secondary cell that is rechargeable, or a fuel cell. At least a portion of the battery 289 may be disposed on, for example, substantially the same plane as that of the PCB assemblies 251 and 252. The battery 289 may be disposed integrally inside the electronic device 201 or may be disposed detachably from the electronic device 201.

In an embodiment, the battery 289 may be accommodated by a battery slot 245 of the second support structure 242 formed between the first substrate slot 242a and the second substrate slot 242b. The battery 289 may include at least one of a first connecting member 289a connected to the first PCB 251 and a second connecting member 289b connected to the second PCB 252.

In an embodiment, a wireless communication circuit (e.g., the wireless communication module 192 of FIG. 1) may be disposed on the PCB assemblies 251 and 252. The wireless communication circuit may perform communication with, for example, an external device (e.g., the electronic device 104 of FIG. 1). The electronic device 201 may include an antenna (e.g., the antenna module 197 of FIG. 1), and the wireless communication circuit may be electrically connected to an antenna structure. In an embodiment, the wireless communication circuit may generate a signal to be transmitted through the antenna structure or may detect a signal received through the antenna structure. In an embodiment, the PCB assemblies 251 and 252 may include the ground, and the ground of the PCB assemblies 251 and 252 may function as the ground of the antenna structure implemented by using the wireless communication circuit.

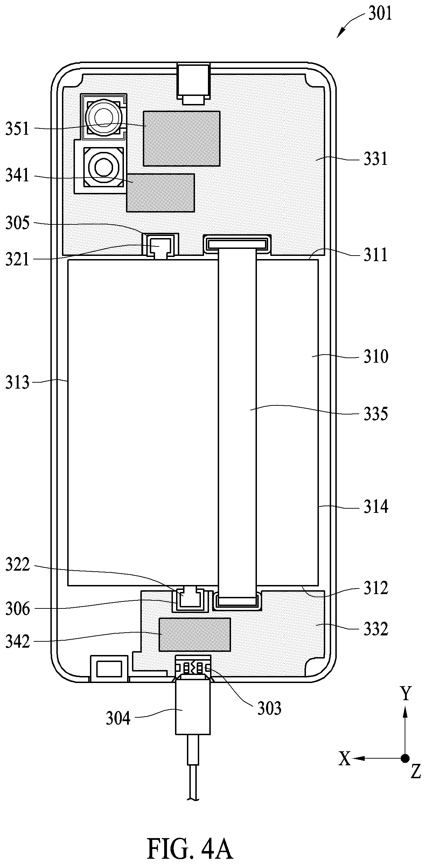

Hereinafter, based on the description of the electronic device 201, various charging and discharging routes of the battery 289 and structures to implement the same are described. Hereinafter, to describe an electronic device (e.g., an electronic device 301 of FIG. 4A and thereafter), a duplicate description with that of the electronic device 201 may not be repeated, and some of the structure and the configuration may be replaced, added, or omitted within a scope in which one of ordinary skill in the art may easily understand.

Although not illustrated in the drawings, the electronic device 201 may include an electromagnetic induction panel (not shown) (e.g., a digitizer). The electromagnetic induction panel (not shown) may be a panel for detecting an input from a pen input device (not shown). For example, the electromagnetic induction panel (not shown) may include a PCB (e.g., a flexible printed circuit board (FPCB)) and a shielding sheet. The shielding sheet may reduce mutual interference resulting from an electromagnetic field generated by the components (e.g., a display module, a PCB, the electromagnetic induction panel, etc.) included in the electronic device 201. The shielding sheet may block the electromagnetic field generated by the components and may enable an input from the pen input device (not shown) to be accurately transmitted to a coil included in the electromagnetic induction panel (not shown). According to various embodiments, the electromagnetic induction panel (not shown) may include an opening formed in at least a partial area corresponding to a biometric sensor mounted in the electronic device 300.

Although not illustrated in the drawings, the antenna (not shown) may be disposed between the rear plate 211b and the battery 289. The antenna (not shown) may include, for example, a near field communication (NFC) antenna, a wireless charging antenna, and/or a magnetic secure transmission (MST) antenna. The antenna (not shown) may perform short-range communication with an external device or may wirelessly transmit and receive power required for charging to and from the external device. In an embodiment, the antenna structure may be formed by the side structure 240 and/or a portion of the first support structure 241 and the second support structure 242 or a combination thereof.

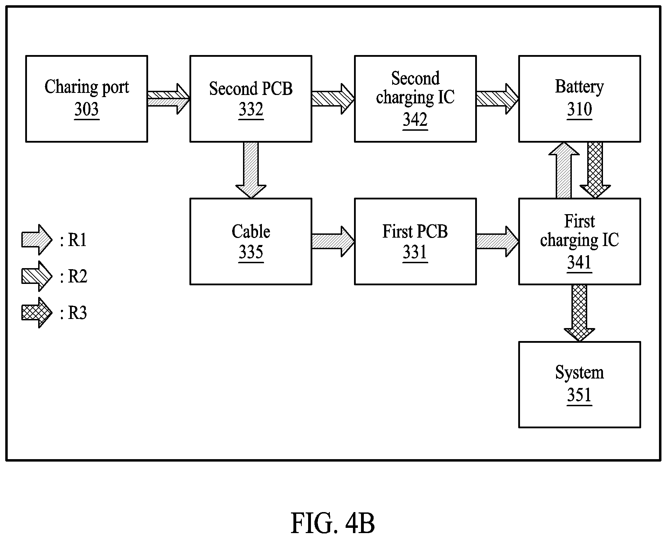

FIG. 4A is a plan view of the electronic device according to an embodiment, and FIG. 4B is a diagram illustrating charging and discharging routes of the electronic device according to an embodiment. For example, the electronic device 301 of FIG. 4A may be a rear view of the electronic device 201 of FIGS. 2A to 3 from which the rear plate 211b is separated.

In an embodiment, the electronic device 301 (e.g., the electronic device 100 of FIG. 1 or the electronic device 201 of FIGS. 2A to 3) may include a first charging IC 341 and a second charging IC 342 that supply power to a battery 310 (e.g., the battery 289 of FIG. 3).

In an embodiment, the electronic device 301 may optionally enable normal charging and fast charging. A charging target of the normal charging and the fast charging may be the battery 310 included by the electronic device 301. In an embodiment, the fast charging may be one of charging methods of applying a current of a larger value than the normal charging to the battery 310 and charging the battery 310 in a relatively short time, and the fast charging may also be referred to as "quick charging". The normal charging may be a method of charging the battery at a general voltage and is distinguished from the fast charging.

In an embodiment, the battery 310 may include a plurality of side surfaces 311, 312, 313, and 314 each facing a side surface direction (e.g., an X-Y plane direction) based on a rear view of the electronic device 301. For example, the first surface 311 may face an upper direction (e.g., a +Y direction) of the electronic device 301, the second surface 312 may face a lower direction (e.g., a -Y direction) of the electronic device 301, and the third surface 313 and the fourth surface 314 may be side surfaces opposite to each other, leading up from the first surface 311 to the second surface 312.

In an embodiment, the battery 310 may include a plurality of connecting members 321 and 322 (e.g., the first connecting member 289a and the second connecting member 289b of FIG. 3). The plurality of connecting members 321 and 322 may include the first connecting member 321 and the second connecting member 322. In an embodiment, the first connecting member 321 and the second connecting member 322 may be formed on any one of the plurality of side surfaces 311, 312, 313, and 314 of the battery 310. The first connecting member 321 and the second connecting member 322 may be formed on two different side surfaces of the plurality of side surfaces 311, 312, 313, and 314.

In an embodiment, the electronic device 301 may include PCB assemblies 331 and 332 (e.g., the PCB assemblies 251 and 252 of FIG. 3) including the first PCB 331 and/or the second PCB 332. For example, at least some of a system 351, the first charging IC 341, and the second charging IC 342 may be positioned in the PCB assemblies 331 and 332.

In an embodiment, the system 351 may refer to various components that consume power to drive the electronic device 301 and, for example, the system may include a processor (e.g., the processor 120 of FIG. 1). The first charging IC 341 and the second charging IC 342 may be disposed adjacent to at least one of the plurality of side surfaces 311, 312, 313, and 314 of the battery 310 and may charge the battery 310.

In an embodiment, the processor 120 may be disposed in the PCB assemblies 331 and 332, for example, in the first PCB 331. The processor 120 may include, for example, one or more of a central processing unit (CPU), an application processor (AP), an image signal processor, a sensor hub processor, or a communication processor.

In an embodiment, the PCB assemblies 331 and 332 may include a third connecting member 305 connected to the first connecting member 321 and a fourth connecting member 306 connected to the second connecting member 322. For example, the third connecting member 305 may be formed in the first PCB 331 correspondingly to the position of the first connecting member 321, and the fourth connecting member 306 may be formed in the second PCB 332 correspondingly to the position of the second connecting member 322.

For example, the first PCB 331 may be connected to the third connecting member 305. The first PCB 331 may be connected to the first connecting member 321 and may be disposed relatively more adjacent to the first surface 311 than the second surface 312 of the battery 310. For another example, the second PCB 332 may be connected to the fourth connecting member 306. The second PCB 332 may be connected to the second connecting member 322 and may be disposed relatively more adjacent to the second surface 312 than the first surface 311 of the battery 310.

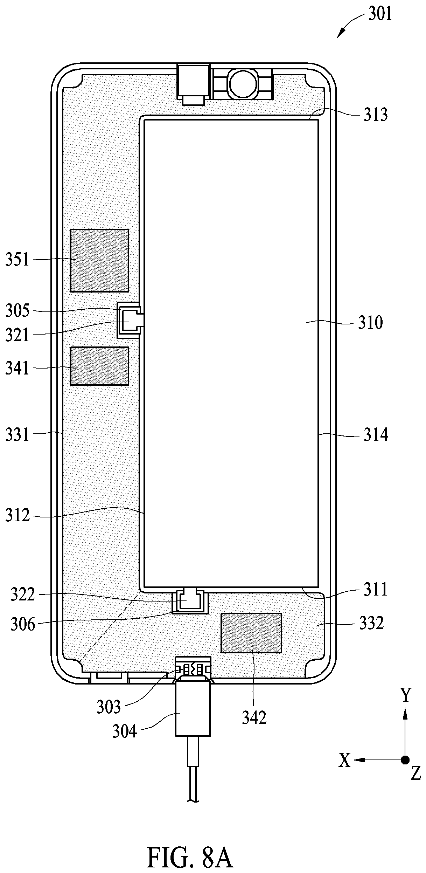

In an embodiment, as illustrated in FIG. 4A, the first surface 311 and the second surface 312 may be surfaces facing mutually opposite directions. For example, the first PCB 331 may be separated and spaced apart from the second PCB 332 with the battery 310 at the center. Examples are not limited thereto, and, as described below with reference to FIG. 8A, the first surface 311 and the second surface 312 may be side surfaces adjacent to each other.

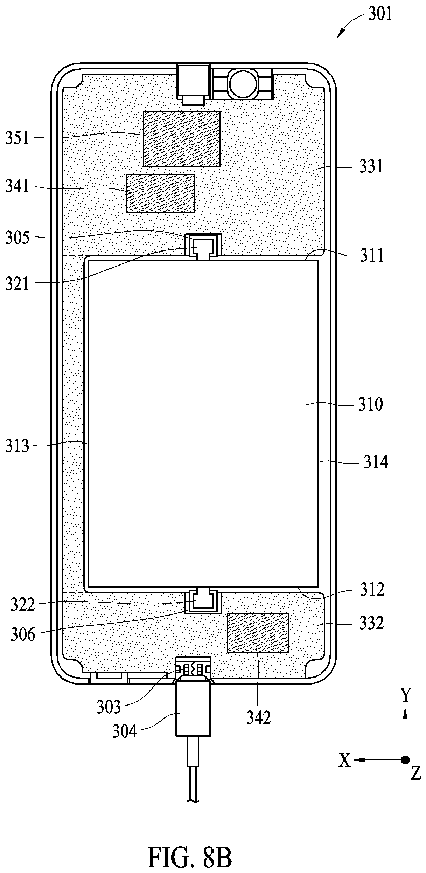

In an embodiment, the first PCB 331 and the second PCB 332 may be implemented as separate PCBs, and the first PCB 331 may be connected to the second PCB 332 through a cable 335 and/or wireless communication. Examples are not limited thereto, and, as described below with reference to FIGS. 8A and 8B, the first PCB 331 and the second PCB 332 may be continuously formed as one body. In this case, the cable 335 may be omitted.

In an embodiment, both ends of the cable 355 may be respectively connected to the first PCB 331 and the second PCB 332, and the first PCB 331 and the second PCB 332 may supply or receive power and/or data to and from each other through the cable 355. In various embodiments, the cable 335 may be a conductive wire or an FPCB.

In an embodiment, an external charging device may be connected to a charging port 303 (e.g., the connecting terminal 278 of FIGS. 2A and 2B), which may thereby receive power from the outside. The power supplied to the charging port 303 may be transmitted to the battery 310 through at least some of the PCB assemblies 331 and 332 and the plurality of charging ICs 341 and 342. In an embodiment, the charging port 303 may be disposed more adjacent to either one than the other one between the first PCB 331 and the second PCB 332. For example, the charging port 303 may be disposed relatively more adjacent to the second PCB 332 than the first PCB 331.

In an embodiment, the system 351, for example, the processor 120 of the system 351, may select one of fast charging and normal charging of the battery 310 based on a charging algorithm. The charging algorithm may determine whether fast charging of the battery 310 is necessary and whether it is an environment where fast charging is possible based on internal and/or external factors of the electronic device 301.

For example, the system 351 may determine whether the external charging device 304 inserted into the charging port 303 is a device that supports fast charging, and, when the device does not support fast charging, may select normal charging.

For example, the system 351 may determine whether a voltage of the battery 310 is within a certain range (e.g., a voltage that is greater than or equal to about 3.5 V and less than or equal to about 4.35 V) and may select normal charging when the voltage is not within the certain range.

For example, the system 351 may determine whether an external temperature is within a certain range (e.g., a temperature that is greater than or equal to about 15 degrees Celsius and less than or equal to about 45 degrees Celsius) and may select normal charging when the temperature is not within the certain range.

For example, the system 351 may determine whether a temperature of an internal component of the battery 310 or the electronic device 301 is within a certain range (e.g., less than about 38 degrees Celsius) and may select normal charging when the temperature is not within the certain range.

For example, the system 351 may simulate a complex heat generation scenario of the electronic device 301 and may select normal charging when an expected heat generation temperature is not within a safe range (e.g., less than about 38 degrees Celsius).

Examples are not limited to the foregoing examples, and the system 351 and the processor 120 may select one of normal charging and fast charging based on various charging algorithms. Hereinafter, the processor 120 is described as a main component that determines a charging algorithm and controls the electronic device 301, but, in actual implementation, the system 351 or a separate controller (not shown) may be the main component.

In an embodiment, the second charging IC 342 may be positioned in the second PCB 332. The second charging IC 342 may include a switching structure controllable by the processor 120. A current flow may be allowed when the switching structure is turned on by the processor 120 and the current flow may be restricted when the switching structure is turned off by the processor 120.

In an embodiment, the first charging IC 341 may be a charging IC for normal charging, and the second charging IC 342 may be a charging IC for fast charging. For example, when the second charging IC 342 is turned on, current transmitted from the charging port 303 mainly flows to the second charging IC 342, and the battery 310 may be fast charged. For example, when the second charging IC 342 is turned off, the current transmitted from the charging port 303 mainly flows to the first charging IC 341, and the battery 310 may be normally charged.

In an embodiment, the processor 120 may select one of normal charging and fast charging based on a charging algorithm and may switch the second charging IC 342 accordingly. The processor 120 may turn off the second charging IC 342 such that current flows to the first charging IC 341 for the normal charging of the battery 310. Alternatively, the processor 120 may turn on the second charging IC 342 such that current flows to the second charging IC 342 for the fast charging of the battery 310.

In an embodiment, as illustrated in FIG. 4B, the electronic device 301 may include a normal charging route R1 for normally charging the battery 310, a fast-charging route R2 for fast charging the battery 310, and a discharging route R3 for discharging power from the battery 310.

In various embodiments, at least some of the normal charging route R1, the fast-charging route R2, and the discharging route R3 may be overlapped, opposite, or individualized in some sections.

In an embodiment, referring to FIGS. 4A and 4B, the electronic device 301 may individualize the normal charging route R1 and the fast-charging route R2. By doing so, power loss and heat generation during fast charging may be reduced, and fast-charging efficiency may be improved.

In an embodiment, when the charging device 304 is connected to the charging port 303, the charging device 304 may be connected to the second PCB 332 and may supply power to the second PCB 332. The processor 120 may switch the second charging IC 342 based on the selection between fast charging and normal charging and may supply power to either one of the normal charging route R1 or the fast-charging route R2.

In an embodiment, compared to the normal charging route R1, the fast-charging route R2 may omit the process of transmitting power through the cable 335 or other components (not shown) and may reduce power loss caused by a current flow.

In an embodiment, in the normal charging route R1, the second PCB 332 may supply power to the first PCB 331 through the cable 335. The first charging IC 341 disposed in the first PCB 331 may supply power from the first PCB 331 to the battery 310 through the first connecting member 321.

In an embodiment, in the fast-charging route R2, the second charging IC 342 disposed in the second PCB 332 may directly supply power from the second PCB 332 to the battery 310 through the second connecting member 322.

In an embodiment, a DC resistance (DCR) of the electronic device 301 may increase due to a contact resistance generated in connecting parts between components where current is transmitted in a charging operation and/or a resistance generated inside each component. For example, fast charging involves a current flow of a relatively high value, and thus, power loss and heat generation may further increase when the DCR is high.

In an embodiment, when the second charging IC 342 is disposed in the first PCB 331, the DCR may increase as current passes through additional components, like the cable 335. In this case, to reduce power loss and heat generation, the thickness of the cable 335 and other components may need to be increased or an upper limit of passing current may need to be lowered. Accordingly, a fast-charging time may increase, or fast-charging efficiency may deteriorate in the electronic device 301.

In various embodiments of the present disclosure, the second charging IC 342 may be disposed in the second PCB 332 adjacent to the charging port 303, and power may be substantially directly supplied from the charging port 303 to the battery 310 through the second charging IC 342. By shortening the fast-charging route R2, the electronic device 301 may reduce the heat generation of the electronic device 301 during fast charging, may reduce the DCR, and may improve fast charging speed and fast-charging efficiency.

In various embodiments of the present disclosure, current may be transmitted to the cable 335 or other components (not shown) only during normal charging such that a relatively high current for fast charging may not flow to the cable 335 and other components (not shown). By simplifying the fast-charging route R2, the electronic device 301 may have advantageous effects in heat dissipation design and the miniaturization and thinning of the electronic device 301 and may increase a capacity of the battery 310 through an extra space.

In an embodiment, when power is required to drive the electronic device 301, the battery 310 may be discharged while supplying power to the system 351. In an embodiment, the discharging route R3 may supply power to the system 351 of the first PCB 331 through the first charging IC 341.

In an embodiment, the first charging IC 341 may control a voltage supplied to the battery 310 for the charging of the battery 310 and may also control a voltage transmitted from the battery 310 to the first PCB 331 for the discharging of the battery 310.

For example, the first charging IC 341 may receive power from the first connecting member 321 and may transmit power to the first PCB 331 to supply power to the first PCB 331 and/or various types of hardware components disposed in the first PCB 331. In various embodiments, the system 351 may dispose various types of hardware components, for example, the processor 120, in the first PCB 331. The first charging IC 341 may provide power to drive the electronic device 301 by supplying power to the first PCB 331.

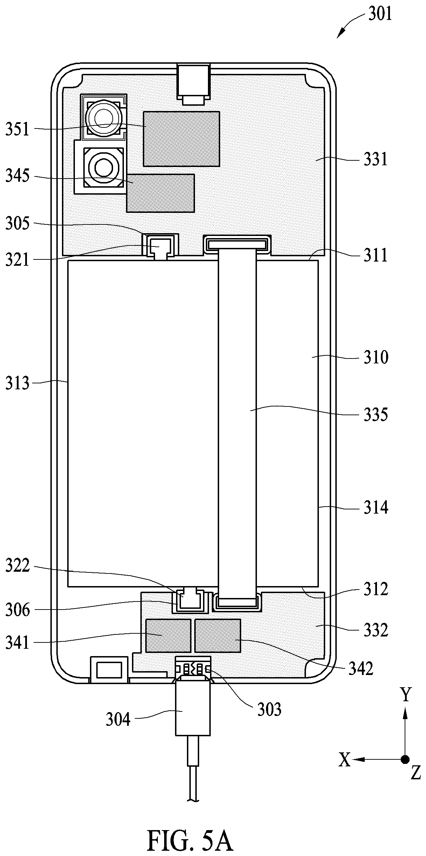

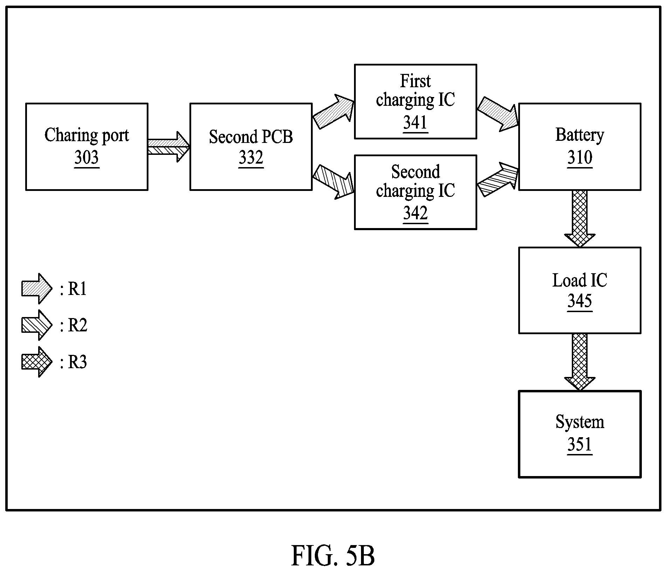

FIG. 5A is a rear view of the electronic device 301 according to an embodiment, and FIG. 5B is a diagram illustrating charging and discharging routes R1, R2, and R3 of the electronic device 301 according to an embodiment.

Hereinafter, in describing the charging and discharging routes R1, R2, and R3 of the electronic device 301, the overlapping description of the descriptions provided above may not be repeated, and a description of different elements is mainly provided.

Referring to FIGS. 5A and 5B, according to various embodiments, the first charging IC 341 may be disposed on the second PCB 332.

In an embodiment, as illustrated in FIG. 5A, the first charging IC 341 is disposed on the second PCB 332 and may directly supply power from the second PCB 332 to the battery 310 through the second connecting member 322. The first charging IC 341 and the second charging IC 342 are disposed on the second PCB 332, and each may directly supply power from the second PCB 332 to the battery 310.

In an embodiment, a load IC 345 for supplying power from the battery 310 to the first PCB 331 may be disposed on the first PCB 331. The load IC 345 may receive power from the first connecting member 321 and transmit power to the first PCB 331. The load IC 345 may control a voltage transmitted from the battery 310 to the first PCB 331 to discharge the battery 310.

In an embodiment, as illustrated in FIG. 5B, the normal charging route R1 and the fast-charging route R2, without passing through the first PCB 331, may directly supply power from the second PCB 332 to the battery 310. The discharging route R3 may supply power to the first PCB 331 through a separate load IC 345 disposed on the first PCB 331.

In an embodiment, the normal charging route R1 of FIGS. 5A and 5B may omit the operation of transmitting power through the cable 335, compared to the normal charging route R1 of FIGS. 4A and 4B, and, by doing so, power loss caused by a current flow may be reduced.

For example, in the normal charging route R1 and the fast-charging route R2, the second PCB 332 does not supply power to the first PCB 331 through the cable 335, and current may selectively flow through either the first charging IC 341 or the second charging IC 342 depending on whether it is normal charging or fast charging.

In an embodiment, the processor 120 may turn on or off the first charging IC 341 based on whether it is fast charging or normal charging, and power supplied from the charging port 303 may be selectively supplied to one of the first charging IC 341 and the second charging IC 342. The first charging IC 341 and the second charging IC 342 may directly supply power from the second PCB 332 to the battery 310 through the second connecting member 322.

In various embodiments of the present disclosure, with both the first charging IC 341 and the second charging IC 342 being disposed on the second PCB 332 adjacent to the charging port 303, power may be substantially directly supplied from the charging port 303 to the battery 310 in both charging routes R1 and R2. By shortening the normal charging route R1 and the fast-charging route R2, the electronic device 301 may reduce the heat generation of the electronic device 301 due to charging, may reduce a DCR, and may improve charging speed and charging efficiency.

In addition, in various embodiments of the present disclosure, power for charging the battery 310 is not substantially transmitted through the cable 335, and thus, the cable 335 may be used to supply a relatively small amount of power and/or data, which may help achieve the miniaturization and slimness of the cable 335.

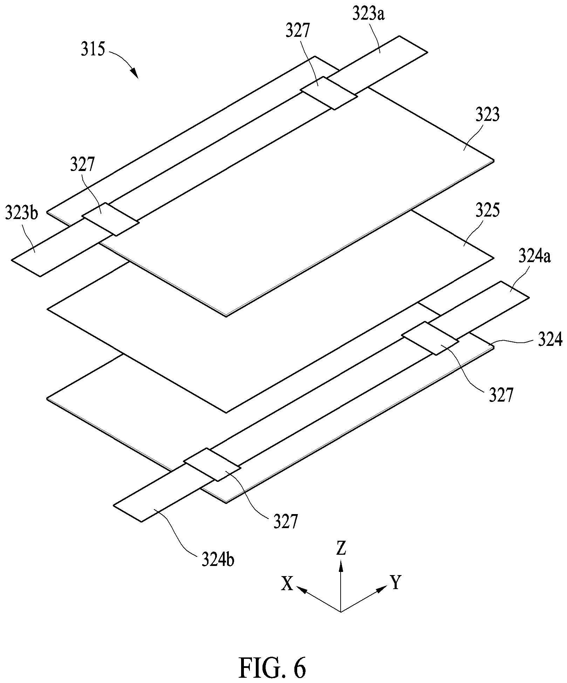

FIG. 6 is a diagram illustrating a multi-layer structure of a battery cell 315 according to an embodiment.

Referring to FIG. 6, the battery 310, according to various embodiments, may include a negative electrode 323, a positive electrode 324, and a separator 325.

In an embodiment, the negative electrode 323 may include a first negative electrode tab 323a extending in a first direction (e.g., a +Y direction) and a second negative electrode tab 323b extending in a second direction (e.g., a -y direction) different from the first direction. The positive electrode 324 may include a first positive electrode tab 324a extending in the first direction and a second positive electrode tab 324b extending in the second direction. The positive electrode 324 and the negative electrode 323 may be electrically separated through the separator 325. As illustrated in FIG. 6, the first direction may be opposite to the second direction. Examples are not limited thereto, and the first direction and the second direction may be perpendicular to each other or may be inclined at a predetermined angle.

In an embodiment, the first negative electrode tab 323a and the second negative electrode tab 323b may be formed as one body and may be attached to the negative electrode 323 through at least one adhesive member 327. In addition, the first positive electrode tab 324a and the second positive electrode tab 324b may be formed as one body and may be attached to the positive electrode 324 through the at least one adhesive member 327.

In an embodiment, the structure of the battery cell 315 may be a stack type where a multi-layer structure including the positive electrode 324 and the separator 325 is repeatedly stacked at least once. For another example, the structure of the battery cell 315 may be a roll type where a multi-layer structure is rolled or a folding type where a multi-layer structure is folded. Examples are not limited thereto, and the cell structure of the battery 310, according to various embodiments of the present disclosure, may be variously implemented such that the first connecting member 321 and the second connecting member 322 are formed in mutually different directions.

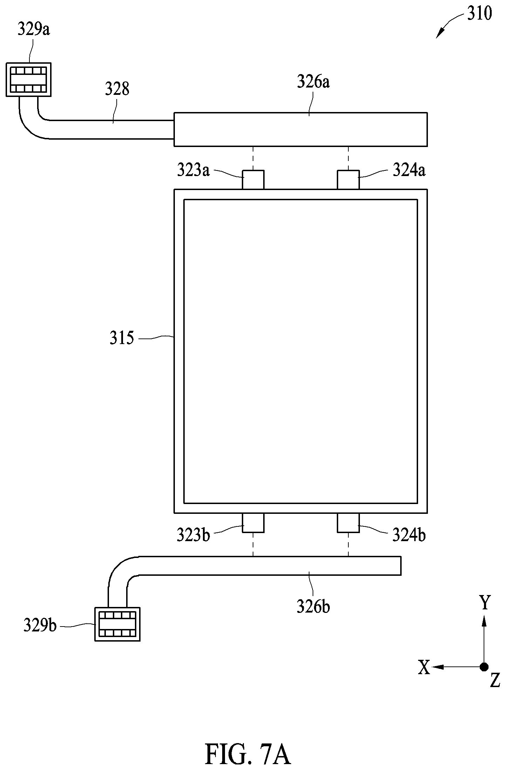

FIGS. 7A to 7D are diagrams illustrating a connection structure of the battery 310 according to an embodiment.

Referring to FIGS. 7A to 7D, the battery 310, according to various embodiments, may include at least some of the various types of protection circuit modules (PCMs) connected to the battery cell 315.

Hereinafter, the connection structure of the battery 310 variously implementable based on the structure of the electronic device 301 and the structure of the battery cell 315 is described, and the descriptions provided above or overlapping descriptions may not be repeated, and a description of different elements is mainly provided. In addition, respective embodiments of FIGS. 7A to 7D may be independent, or some of the structures and configurations may be replaced with one another and some structures may be added or omitted.

As illustrated in FIG. 7A, the first negative electrode tab 323a and the first positive tab 324a in the battery cell 315, in an embodiment, may be exposed in a first direction (e.g., a +Y direction), and each may be connected to a first PCM 326a to be connected to the first connecting member 321. The second negative electrode tab 323b and the second positive tab 323a in the battery cell 315 may be exposed in a second direction (e.g., a -Y direction), and each may be connected to a second PCM 326b to be connected to the second connecting member 322.

In an embodiment, the first PCM 326a and the second PCM 326b may control a voltage to inhibit the battery 310 from being overcharged and/or over-discharged during the charging and/or discharging of the battery cell 315.

For example, in the case of the electronic device 301 of FIGS. 4A and 4B, the first PCM 326a may protect the battery cell 315 for the normal charging and discharging of the battery 310, and the second PCM 326b may protect the battery 310 for the fast charging of the battery 310.

In an embodiment, the first connecting member 321 and the second connecting member 322 may be electrically connected to the third connecting member 305 and the fourth connecting member 306 through access members 329a and 329b, respectively. For example, the first PCB 331 may be connected to the first access member 329a through an intermediate member 328 formed of an FPCB or a conductive wire.

In an embodiment, the second PCM 326b may be implemented as an FPCB or may be directly connected to the second access member 329b. In various embodiments, the first access member 329a may be directly connected to the third connecting member 305 of the first PCB 331, and the second access member 329b may be directly connected to the fourth connecting member 305 of the second PCB 332.

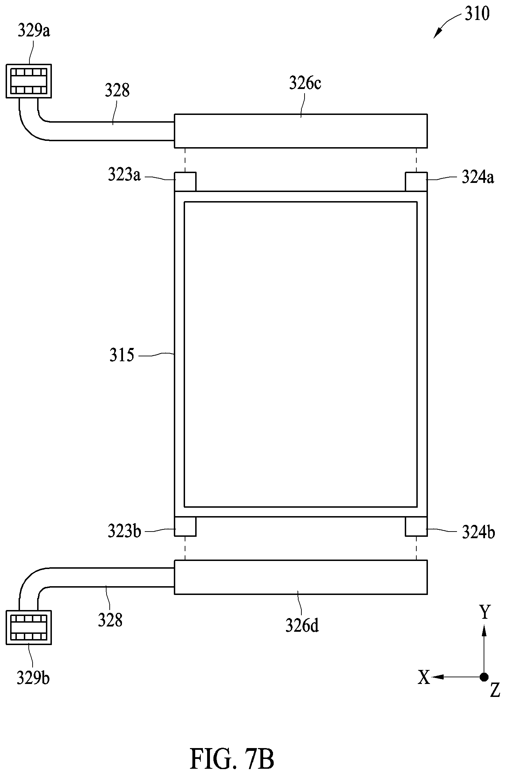

As illustrated in FIG. 7B, in an embodiment, a plurality of positive electrode tabs 324a and 324b and a plurality of negative electrode tabs 323a and 323b may be formed closely on both sides. For example, the first negative electrode tab 323a and the first positive electrode tab 324a may be spaced apart from each other and may be formed closely to a pair of side surfaces 313 and 314 of the battery 310, respectively, and the second negative electrode tab 323b and the second positive electrode tab 324b may be spaced apart from each other and may be formed closely to the pair of side surfaces 313 and 314 of the battery 310, respectively.

In an embodiment, the first negative electrode tab 323a and the first positive tab 324a in the battery cell 315 may be exposed in the first direction (e.g., the +Y direction), and each may be connected to a third PCM 326c to form the first connecting member 321. The second negative electrode tab 323b and the second positive tab 323a in the battery cell 315 may be exposed in the second direction (e.g., the -Y direction), and each may be connected to a fourth PCM 326d to form the second connecting member 322.

In an embodiment, the second PCM 326c and the fourth PCM 326d may control a voltage to inhibit the battery 310 from being overcharged and/or over-discharged during the charging and/or discharging of the battery cell 315.

For example, in the case of the electronic device 301 of FIGS. 5A and 5B, the third PCM 326c may protect the battery 310 for the discharging of the battery 310, and the fourth PCM 326d may protect the battery cell 315 for the normal charging and fast charging of the battery 310.

In an embodiment, the fourth PCM 326d may have substantially the same connection structure as that of the first PCM 326a or the third PCM 326c, unlike the structure of the second PCM 326b in FIG. 7A. For example, both the third PCM 326c and the fourth PCM 326d may be connected to the first access member 329a and the second access member 329b through the intermediate member 328.

In various embodiments, the plurality of negative electrode tabs 323a and 323b and the plurality of positive electrode tabs 324a and 324b may be formed at various positions in the battery cell 315 and may be connected to a PCM of various structures and shapes. As a result, the shape and structure of the battery 310 may be implemented in various ways, and the degree of freedom in the design of the electronic device 301 where the battery 310 is disposed may increase.

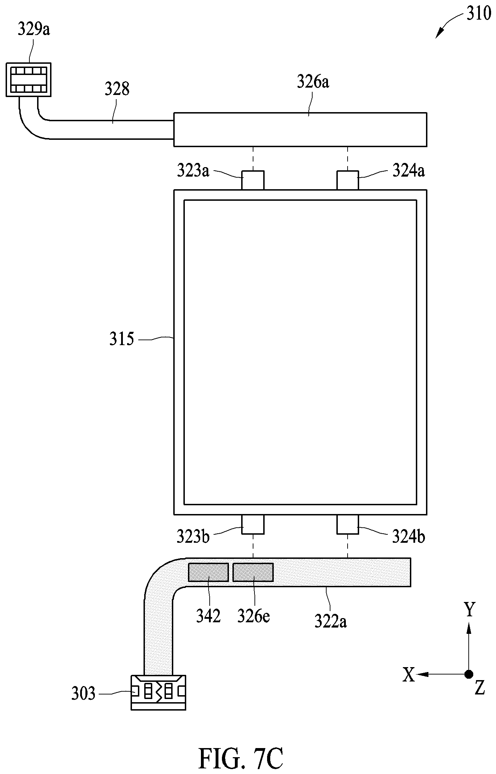

As illustrated in FIG. 7C, the second negative electrode tab 323b and the second positive electrode tab 324b of the battery cell 315 may be directly connected to a separate battery PCB 322a. A PCM IC 326e and the second charging IC 342 may be disposed on the battery PCB 322a. The battery PCB 322a may be connected to the charging port 303 through the second access member 329b. In various embodiments, the battery PCB 322a may effectively reduce a DCR and may improve charging efficiency by reducing components and connecting points leading up to the battery cell 315.

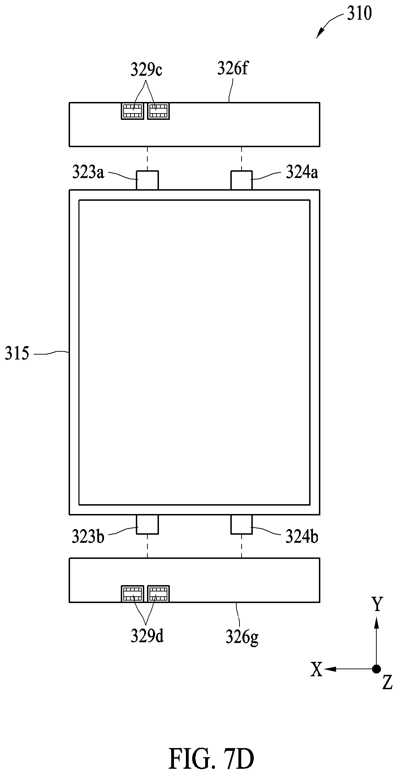

As illustrated in FIG. 7D, the first negative electrode tab 323a and the first positive tab 324a in the battery cell 315 may be exposed in the first direction (e.g., the +Y direction), and each may be connected to a fifth PCM 326f to form the first connecting member 321. The second negative electrode tab 323b and the second positive tab 323a in the battery cell 315 may be exposed in the second direction (e.g., the -Y direction), and each may be connected to a sixth PCM 326g to form the second connecting member 322.

In an embodiment, the fifth PCM 326f and the sixth PCM 326g may not include a separate FPCB or the intermediate member 328. The fifth PCM 326f may include a first contact pad 329c connected to the third connecting member 305 and having positive and negative contact parts, and the sixth PCM 326g may include a second contact pad 329d connected to the fourth connecting member 306 and having positive and negative contact parts.

FIGS. 8A and 8B are rear views of the electronic device 301 according to an embodiment.

Referring to FIGS. 8A and 8B, the first PCB 331 and the second PCB 332 may be continuous and implemented as one body.

Hereinafter, the connection structure of the battery 310 variously implementable based on the above-described structure of the electronic device 301 and the structure of the battery cell 315 is described, and the descriptions provided above or overlapping descriptions may not be repeated, and a description of different elements is mainly provided.

In an embodiment, the PCB assemblies 331 and 332 may be continuously formed in one body, and two or more PCBs may be physically connected through a medium.

For example, the PCB assemblies 331 and 332 may be a continuous single board, and the first PCB 331 may be the 'first PCB section 331' of the PCB assemblies 331 and 332, and the second PCB 332 may be the 'second PCB section 332' of the PCB assemblies 331 and 332. The first PCB section 331 and the second PCB section 332 may be implemented as one body to form the PCB assemblies 331 and 332.

Hereinafter, for ease of description, the first PCB 331 is referred to as the first PCB section 331 and the second PCB 332 is referred to as the second PCB section 332. The 'first PCB section 331' may be understood as substantially the same as or similar to the 'first PCB 331' and the 'second PCB section 332' may be understood as substantially the same as or similar to the 'second PCB 332' in various embodiments.

As illustrated in FIG. 8A, the battery 310 may include the first surface 311, the second surface 312, the third surface 313, or the fourth surface 314. The first surface 311 and the second surface 312 may be adjacent surfaces, in which an end of each surface contacts an end of the other surface. The third surface 313 may be a surface facing the first surface 311, and the fourth surface 314 may be a surface facing the second surface 312.

In various embodiments, the first PCB section 331 and the second PCB section 332 may be formed as an integral substrate in a structure surrounding the first surface 311 of the battery 310 and the second surface 312 of the battery 310. In an embodiment, the first PCB section 331 and the second PCB section 332 may be formed as an integral substrate surrounding the first surface 311, second surface 312, and third surface 313 of the battery 310.

In an embodiment, the second charging IC 342 may be disposed in the second PCB section 332 and may directly supply power from the second PCB section 332 to the battery 310 through the second connecting member 322. The first charging IC 341 may be disposed in the first PCB section 331 and may receive power from the second PCB section 332 through a separate cable (not shown) or a wiring structure of the PCB assemblies 331 and 332.

As illustrated in FIG. 8B, the first surface 311 and the second surface 312 may face mutually opposite directions and may be spaced apart from each other. The PCB assemblies 331 and 332 may connect the first PCB section 331 to the second PCB section 332 and may further include a third PCB section 333 facing the third surface 313 of the battery 310.

In an embodiment, the first PCB section 331, the second PCB section 332, and the third PCB section 333 may be formed as a substrate continuously formed as one body in a structure surrounding the first surface 311, second surface 312, and third surface 313 of the battery 310.

In an embodiment, the second charging IC 342 may be disposed in the second PCB section 332 and may directly supply power from the second PCB section 332 to the battery 310 through the second connecting member 322. The first charging IC 341 may be disposed in the first PCB section 331 and may receive power from the second PCB section 332 through the separate cable (not shown) or a wiring structure of the third PCB section 333.

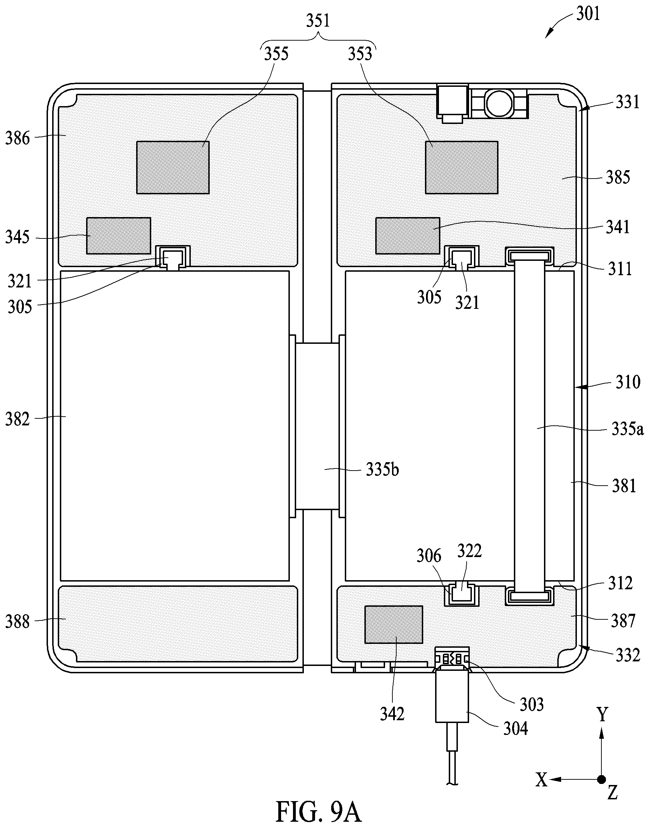

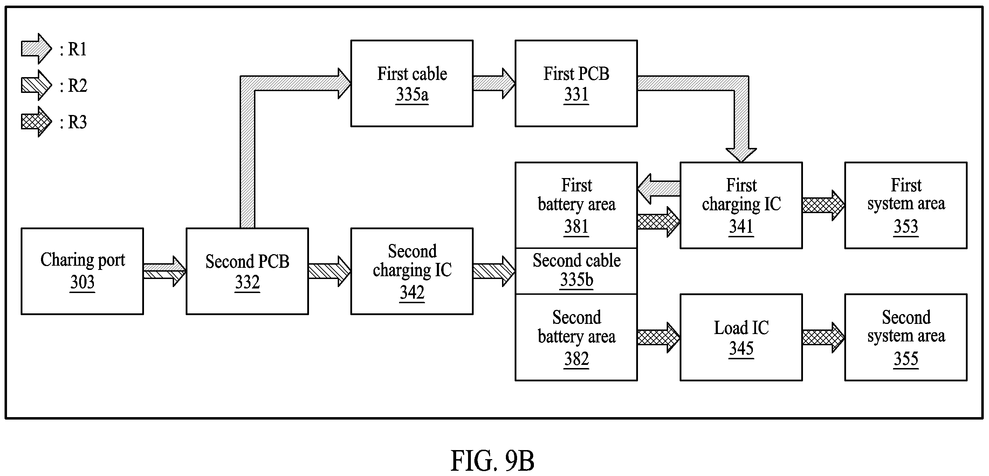

FIG. 9A is a rear view of the electronic device 301 according to an embodiment, and FIG. 9B is a diagram illustrating the charging and discharging routes of the electronic device 301 according to an embodiment.

Hereinafter, the connection structure of the battery 310 variously implementable based on the above-described structure of the electronic device 301 and the structure of the battery cell 315 is described, and the descriptions provided above or overlapping descriptions may not be repeated, and a description of different elements is mainly provided.

Referring to FIGS. 9A and 9B, the electronic device 301, according to various embodiments, may be in a foldable structure including a first housing 381 and a second housing 382.

In an embodiment, the electronic device 301 may be formed in a foldable structure including the first housing 381 and the second housing 382 foldable at a predetermined angle to the first housing 381. The first housing 381 and the second housing 382 may be electrically connected through a second cable 335b. In various embodiments, the second cable 335b may transmit power and/or data between the first housing 381 and the second housing 382.

In an embodiment, the electronic device 301 may include a first sub-PCB 385 of the first PCB 331 disposed in the first housing 381 and a second sub-PCB 386 of the first PCB 331 disposed in the second housing 382.

For example, the first sub-PCB 385 and the second sub-PCB 386 are components of the above-described first PCB 331 and may be separately disposed in the first housing 381 and the second housing 382. The first sub-PCB 385 of the first PCB 331 and the second sub-PCB 386 of the first PCB 331 may be physically separated from each other.

In an embodiment, the electronic device 301 may include a third sub-PCB 387 of the second PCB 332 disposed in the second housing 382 and a fourth sub-PCB 388 of the second PCB 332 disposed in the second housing 382.

For example, the third sub-PCB 387 and the fourth sub-PCB 388 are components of the above-described second PCB 332 and may be separately disposed in the first housing 381 and the second housing 382. The third sub-PCB 387 of the second PCB 332 and the fourth sub-PCB 388 of the second PCB 332 may be physically separated from each other.

In an embodiment, the battery 310 may include a first battery area 383 disposed in the first housing 381 and a second battery area 384 disposed in the second housing 382. In an embodiment, the battery 310 may include a plurality of first connecting members 321 and the second connecting members 322. For example, one first connecting member 321 may be connected to the third connecting member 305 of the first sub-PCB 385, the other first connecting member 321 may be connected to the second sub-PCB 386, and the second connecting member 322 may be connected to the fourth connecting member 306 of the third sub-PCB 387.

In an embodiment, both ends of a first cable 355a may be respectively connected to the first sub-PCB 385 and the third sub-PCB 387, and at least some of the plurality of sub-PCBs 385, 386, 387, and 388 may supply or receive power and/or data to and from one another through the first cable 355a.

In an embodiment, both ends of a second cable 335b may be connected respectively to the first battery area 383 and the second battery area 384, and the first battery area 383 and the second battery area 384 may supply or receive power to or from each other through the second cable 335b. The second cable 335b may electrically connect the first housing 381 to the second housing 382 and may transmit power and/or data. For example, the second cable 335b may electrically connect the first sub-PCB 385 to the second sub-PCB 386. In various embodiments, each of the first cable 335a and the second cable 335b may be a conductive wire or an FPCB.

In an embodiment, the first charging IC 341 may be disposed on the first sub-PCB 385, and the second charging IC 342 may be disposed on the third sub-PCB 387. In an embodiment, the charging port 303 may be formed adjacent to the third sub-PCB 387 and may supply power to the second connecting member 322 of the battery 310 through the second charging IC 342 disposed on the third sub-PCB 387. In an embodiment, the load IC 345 may be disposed on the second sub-PCB 386.

In an embodiment, the system 351 may include a first system section 353 and/or a second system section 355 that control the operation of the electronic device 301, and the first system section 353 may be disposed on the first sub-PCB 385 and the second system section 355 may be disposed on the second sub-PCB 386.

In an embodiment, in the normal charging route R1, the second PCB 332 (or the third sub-PCB 387) may supply power to the first PCB 331 (or at least one of the first sub-PCB 385 and the second sub-PCB 386) through the first cable 335a. The first charging IC 341 disposed on the first PCB 331 (or at least one of the first sub-PCB 385 and the second sub-PCB 386) may supply power from the first PCB 331 (or at least one of the first sub-PCB 385 and the second sub-PCB 386) to the first battery area 383 through the first connecting member 321.

In an embodiment, in the fast-charging route R2, the second charging IC 342 disposed in the second PCB 332 (or the third sub-PCB 387) may directly supply power from the second PCB 332 (or the third sub-PCB 387) to the first battery area 383 through the second connecting member 322.

In an embodiment, power supplied to the first battery area 383 through fast charging and/or normal charging may be supplied to the second battery area 384 through the cable 335.

In an embodiment, the discharging route R3 may supply power to the first system section 353 and/or the second system section 355, and the discharging route R3 may be dualized. For example, to supply power to the first system section 353, the first battery area 383 may supply power to the first sub-PCB 385 through the first charging IC 341. For example, to supply power to the second system section 355, the second battery area 384 may supply power to the second sub-PCB 386 through the load IC 345.

According to various embodiments, an electronic device 301 includes: a battery 310 including a first surface 311 and a second surface 312 facing a different direction than the first surface and including the first connector 321 and the second connector 322, the first printed circuit board (PCB) 331 connected to the first connector 321 and relatively closer to the first surface 311 than the second surface 312 of the battery 310, a second PCB 332 connected to the second connector 322 and relatively closer to the second surface 312 than the first surface 311 of the battery 310, the first charging IC 341 and the second charging IC 342 that are configured to supply power to the battery 310, the processor 120 disposed on the first PCB 331 and configured to select between fast charging and normal charging of the battery 310 based on a charging algorithm, and a charging port 303 connected to the second PCB 332, in which the processor 120 is configured to turn off the second charging IC 342 for the normal charging of the battery 310 and configured to turn on the second charging IC 342 for the fast charging of the battery 310, and the second charging IC 342 is disposed on the second PCB 332 and configured to supply power from the second PCB 332 to the battery 310 through the second connector.

In various example embodiments, the electronic device 301 may include the cable 335 configured to supply power from the second PCB 332 to the first PCB 331, and the first charging IC 341 may be disposed on the first PCB 331 and may supply power from the first PCB 331 to the battery 310 through the first connector.

In various embodiments, the first charging IC 341 may be configured to receive power from the first connector and may be configured to transmit power to the first PCB 331 to supply power to the first PCB 331.

In various embodiments, the first charging IC 341 may be disposed on the second PCB 332 and may be configured to directly supply power from the second PCB 332 to the battery 310 through the second connector 322.

In various embodiments, the electronic device 301 may include the load IC 345 disposed on the first PCB 331 and may be configured to receive power from the first connector 321 and may be configured to transmit power to the first PCB 331 to supply power to the first PCB 331.

In various embodiments, the second surface 312 may face an opposite direction to the first surface 311.

In various embodiments, the first PCB 331 may be separated and spaced apart from the second PCB 332 with the battery in between.

In various embodiments, the battery 310 may include a third surface 313 leading up from the first surface 311 to the second surface 312, and the electronic device 310 may include the third PCB 333 connecting the first PCB 331 to the second PCB 332 and facing the third surface 313 of the battery 310.

In various embodiments, the first PCB 331, the second PCB 332, and the third PCB 333 may be comprise one body.

In various embodiments, the first surface 311 and the second surface 312 may be adjacent surfaces, wherein one end of each surface contacts one end of the other surface.

In various embodiments, the first PCB 331 and the second PCB 332 may comprise one body.

In various embodiments, the battery 310 may include the negative electrode 323 including the first negative electrode tab 323a extending in a first direction and the second negative electrode tab 323b extending in a second direction different from the first direction, the positive electrode 324 including the first positive electrode tab 324a extending in the first direction and the second positive electrode tab 324b extending in the second direction, and the separator 325 configured to separate the negative electrode 323 and the positive electrode 324, wherein the first negative electrode tab 323a and the first positive electrode tab 324a may be connected to the first connector 321, and the second negative electrode tab 323b and the second positive electrode tab 324b may be connected to the second connector 322.

In various embodiments, the battery 310 may include a first protection circuit module (PCM), comprising circuitry 326a connected to each of the first negative electrode tab 323a and the first positive electrode tab 324a and configured to normally charge or discharge the battery 310 and a second PCM 326b connected to each of the second negative electrode tab 323b and the second positive electrode tab 324b and configured to fast charge the battery 310.

In various embodiments, the battery 310 may include a third PCM 326c connected to each of the first negative electrode tab 323a and the first positive electrode tab 324a and configured to discharge the battery 310 and a fourth PCM 326d connected to each of the second negative electrode tab 323b and the second positive electrode tab 324b and configured to normally charge and fast charge the battery 310.

In various embodiments, the first negative electrode tab 323a and the first positive electrode tab 324a may be spaced apart from each other and may each be formed by adhering to each of a pair of side surfaces 313 and 314.

In addition, according to various embodiments, the electronic device 301 includes the battery 310 including the first surface 311 and the second surface 312 facing a different direction than the first surface and including the first connector 321 and a second connector 322, a first printed circuit board (PCB) 331 connected to the first connector 321 and relatively closer to the first surface 311 than the second surface 312 of the battery 310, the second PCB 332 connected to the second connector 322 and relatively closer to the second surface 312 than the first surface 311 of the battery 310, the first charging IC 341 and the second charging IC 342 that are configured to supply power to the battery 310, the cable 335 configured to supply power from the second PCB 332 to the first PCB 331, the processor 120 disposed on the first PCB 331 and configured to select between fast charging and normal charging of the battery 310 based on a charging algorithm, and the charging port 303 connected to the second PCB 332, in which the processor 120 is configured to turn off the second charging IC 342 for normal charging of the battery 310 and configured to turn on the second charging IC 342 for fast charging of the battery 310, the first charging IC 341 is disposed on the first PCB 331 and configured to supply power from the first PCB 331 to the battery 310 through the first connector 321, wherein the second charging IC 342 is disposed on the second PCB 332 and configured to supply power from the second PCB 332 to the battery 310 through the second connector 322.

In various embodiments, the first charging IC 341 may be configured to receive power from the first connector 321 and may be configured to transmit power to the first PCB 331 to supply power to the first PCB 331.

In various embodiments, the second surface 312 may face an opposite direction to the first surface 311, and the first PCB 331 may be separated and spaced apart from the second PCB 332 with the battery 310 in between.

According to various embodiments, the electronic device 301 includes the battery 310 including the first surface 311 and the second surface 312 facing a different direction than the first surface and including the first connector 321 and a second connector 322, printed circuit board (PCB) assemblies 331 and 332 including the first PCB section 331 connected to the first connector 321 and relatively closer to the first surface 311 than the second surface 312 of the battery 310, the second PCB section 332 connected to the second connector 322 and relatively closer to the second surface 312 than the first surface 311 of the battery 310, the first charging IC 341 and the second charging IC 342 that are configured to supply power to the battery 310, the processor 120 disposed on the first PCB section 331 and configured to select between fast charging and normal charging of the battery 310 based on a charging algorithm, and the charging port 303 connected to the second PCB section 332, in which the processor 120 is configured to turn off the second charging IC 342 for normal charging of the battery 310 and configured to turn on the second charging IC 342 for fast charging of the battery 310, wherein the second charging IC 342 is disposed on the second PCB section 332 and configured to supply power from the second PCB section 332 to the battery 310 through the second connector 322.

According to various embodiments, the electronic device 301 formed in a foldable structure including the first housing 381 and the second housing 382 foldable at a specified angle to the first housing 381 includes the battery 310 including the first battery area 383 in the first housing 381 and the second battery area 384 in the second housing 382 and including the a plurality of first connectors 321 facing a first direction and the second connector 322 facing a second direction opposite to the first direction, the first sub-PCB 385 disposed in the first housing 381 and connected to one of the plurality of first connectors 321, the second sub-PCB 386 disposed in the second housing 382 and connected to another one of the plurality of first connectors 321, a third sub-PCB 387 disposed in the first housing 381 and connected to the second connectors 322, the first charging IC 341 and the second charging IC 342 that are configured to supply power to the battery 310, the processor 120 disposed on any one of the first sub-PCB 385 and the second sub-PCB 386 and configured to select between fast charging and normal charging of the battery 310 based on a charging algorithm, and the charging port 303 connected to the third sub-PCB 387, in which the processor 120 is configured to turn off the second charging IC 342 for the normal charging of the battery 310 and configured to turn on the second charging IC 342 for the fast charging of the battery 310, in which the second charging IC 342 is disposed on the third sub-PCB 387 and configured to supply power from the third sub-PCB 387 to the battery 310 through the second connector 322.

Although desirable embodiments are illustrated and described above, the present disclosure is not limited to said certain embodiments, various applications may surely be performed by those skilled in the art without deviating from what is claimed in the scope of claims, and such applications should not be understood separately from the technical idea or prospects herein.

## Claims

1. An electronic device optionally capable of normal charging and fast charging, the electronic device comprising:
a battery comprising a first surface and a second surface facing a different direction than the first surface and comprising a first connector and a second connector;
a first printed circuit board (PCB) connected to the first connector and
relatively closer to the first surface than the second surface of the battery;
a second PCB connected to the second connector and relatively closer to the second surface than the first surface of the battery;
a first charging integrated circuit (IC) and a second charging IC that are configured to supply power to the battery;
a processor disposed on the first PCB and configured to select between fast charging and normal charging of the battery based on a charging algorithm; and
a charging port connected to the second PCB,
wherein the processor is configured to turn off the second charging IC for normal charging of the battery and configured to turn on the second charging IC for fast charging of the battery,
wherein the second charging IC is disposed on the second PCB and
configured to supply power from the second PCB to the battery through the second connector.

2. The electronic device of claim 1, comprising:
a cable configured to supply power from the second PCB to the first PCB,
wherein the first charging IC is disposed on the first PCB and configured to supply power from the first PCB to the battery through the first connector.

3. The electronic device of claim 1 or 2, wherein
the first charging IC is configured to:
receive power from the first connector and transmit power to the first PCB to supply power to the first PCB.

4. The electronic device of any one of claims 1 to 3, wherein
the first charging IC is:
disposed on the second PCB and configured to directly supply power from the second PCB to the battery through the second connector.

5. The electronic device of any one of claims 1 to 4, comprising:
a load IC disposed on the first PCB and configured to receive power from the first connector and transmit power to the first PCB to supply power to the first PCB.

6. The electronic device of any one of claims 1 to 5, wherein
the second surface faces an opposite direction to the first surface.

7. The electronic device of any one of claims 1 to 6, wherein
the first PCB is separated and spaced apart from the second PCB with the battery in between.

8. The electronic device of any one of claims 1 to 7, wherein
the battery comprises a third surface leading from the first surface to the second surface, and
the electronic device comprises a third PCB connecting the first PCB to the second PCB and facing the third surface of the battery.

9. The electronic device of any one of claims 1 to 8, wherein
the first PCB, the second PCB, and the third PCB comprise one body.

10. The electronic device of any one of claims 1 to 9, wherein
the first surface and the second surface are adjacent surfaces, wherein one end of each surface contacts one end of the other surface.

11. The electronic device of any one of claims 1 to 10, wherein the first PCB and the second PCB comprise one body.

12. The electronic device of any one of claims 1 to 11, wherein
the battery comprises:
a negative electrode comprising a first negative electrode tab extending in a first direction and a second negative electrode tab extending in a second direction different from the first direction, a positive electrode comprising a first positive electrode tab extending in the first direction and a second positive electrode tab extending in the second direction,
and a separator configured to separate the negative electrode and the positive electrode,
wherein the first negative electrode tab and the first positive electrode tab are connected to the first connector, and
the second negative electrode tab and the second positive electrode tab are connected to the second connector.

13. The electronic device of any one of claims 1 to 12, wherein
the battery comprises:
a first protection circuit module (PCM) connected to each of the first negative electrode tab and the first positive electrode tab and configured to normally charge or discharge the battery; and
a second PCM connected to each of the second negative electrode tab and the second positive electrode tab and configured to fast charge the battery.

14. The electronic device of any one of claims 1 to 13, wherein the battery comprises:
a third PCM connected to each of the first negative electrode tab and the first positive electrode tab and configured to discharge the battery; and
a fourth PCM connected to each of the second negative electrode tab and
the second positive electrode tab and configured to normally charge and fast charge the battery.

15. The electronic device of any one of claims 1 to 14, wherein
the first negative electrode tab and the first positive electrode tab are spaced apart from each other and each formed by adhering to each of a pair of side surfaces,
the second negative electrode tab and the second positive electrode tab are spaced apart from each other and each formed by adhering to each of the pair of side surfaces.
